(19) Europäisches Patentamt
European Patent Office
Office européen des brevets

(11) EP 0 595 329 B1

(12) **EUROPEAN PATENT SPECIFICATION**

(45) Date of publication and mention
of the grant of the patent:
**03.02.1999  Bulletin 1999/05**

(51) Int Cl.6: **G11C 7/00**, G11C 11/409

(21) Application number: **93117514.5**

(22) Date of filing: **28.10.1993**

(54) **Semiconductor memory device**

Halbleiterspeicheranordnung

Dispositif de mémoire à semi-conducteurs

(84) Designated Contracting States:
**DE FR GB IT NL**

(30) Priority: **28.10.1992  JP 313028/92**

(43) Date of publication of application:
**04.05.1994  Bulletin 1994/18**

(73) Proprietor: **NEC CORPORATION**
**Tokyo (JP)**

(72) Inventor: **Ogawa, Sumio, c/o Nec Corporation**
**Tokyo (JP)**

(74) Representative: **VOSSIUS & PARTNER**
**Siebertstrasse 4**
**81675 München (DE)**

(56) References cited:
**US-A- 4 669 063**          **US-A- 4 853 897**

- **PATENT ABSTRACTS OF JAPAN vol. 10, no. 26
(P-425) 31 January 1986 & JP-A-60 177 495
(NIPPON DENKI)**
- **PATENT ABSTRACTS OF JAPAN vol. 15, no. 319
(E-1100) 14 August 1991 & JP-A-03 117 113
(HITACHI)**

## Description

The present invention relates to a semiconductor memory device, in particular, to a memory device having sense amplifiers and dummy cells which occupy small areas and operate with no error.

With increase of integration density of semiconductor memory devices, each memory cell has decreased its size and capability for biasing a bit line so as to output stored data. In order to detect such a small voltage correctly, there has been provided a dummy cell for supplying a certain voltage to one input node of a differential sense amplifier while another input node is connected to a memory cell to read a data.

US-A-4 853 897 discloses a complementary semiconductor memory device. Therein, a semiconductor memory device is described, according to which a memory cell array is formed in a well region separated away from a dummy cell and a bit line driver.

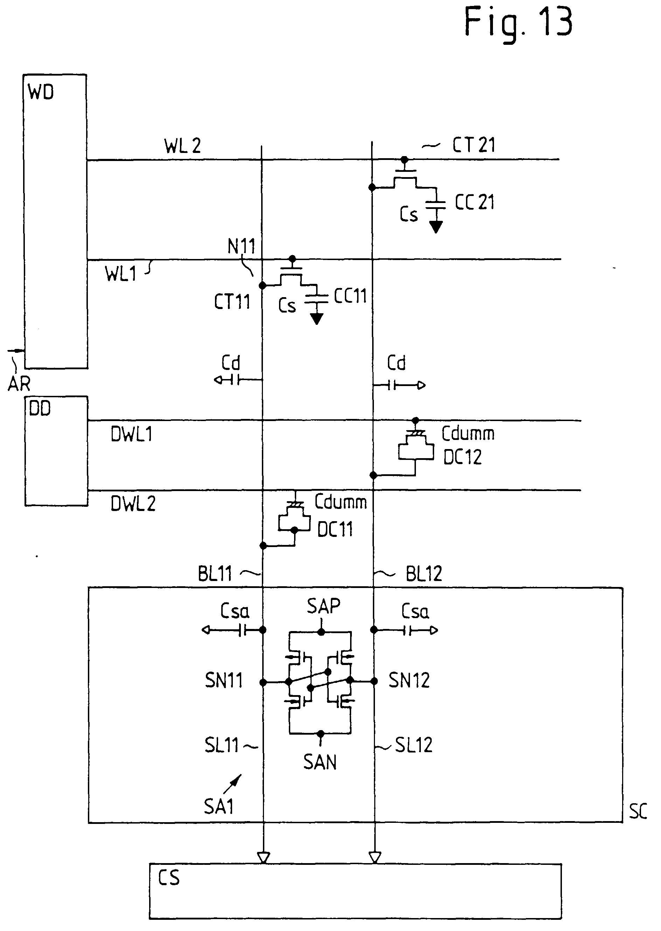

An example of semiconductor memory device having sense amplifiers with dummy cells is shown in Figure 13. Each sense amplifier SA1 formed in a sense amplifier circuit SC is connected to a pair of bit lines BL11, BL12. A word driver WD selectively drives one of word lines WL1, WL2 according to an address signal AR. In this case, each memory cell capacitor CC11, CC21 and each bit line BL11, BL12 have a capacitance Cs and a parasitic capacitance Cd respectively. Each sense amplifier SA11 also has a parasitic capacitance Csa on each signal line SL11, SL12. Each of the memory cell capacitors CC11, CC21 stores data as an amount of charge thereof.

Moreover, the dummy memory cell capacitors DC11, DC12 having a capacitance Cdumm are connected between the bit lines BL11, BL12 and the dummy word lines WL1, WL2 as shown in Figure 13. The bit lines BL11, BL12 and the signal line SL11, SL12 are precharged to $(1/2)$Vcc wherein Vcc represents a power source voltage of the device. The dummy word lines DWL1, DWL2 are maintained at the voltage Vcc.

According to this configuration, when a word line WL1 is selected and a memory cell capacitor CC11 is connected to a bit line BL11 via a memory cell transistor CT11, the charge of the cell capacitor CC11 is distributed among the bit line BL11, the signal line SL11 and the cell capacitor CC11. That is, if the voltage on the memory cell node N11 at the preceding write or refresh mode is $(1/2)$Vcc+Vr, the voltage Vn11 of the node N11 becomes as follows:

$$Vn11 = (1/2)Vcc+(Cs/(Cd+Csa+Cs))Vr,$$

in a balanced state, which is the same as the voltage Vsn11 of the sense amplifier node SN11. In this case, the value of Vr, that is $+(1/2)$Vcc or $-(1/2)$Vcc, is determined according to the data to be written into the cell capacitor CC11. That is, the voltage of the cell node N11 at the write or refresh mode is, Vcc for "written" state, or, Vss for "non-written" state, wherein Vss represents the ground voltage. Meanwhile, the voltage Vsn12 of the other node SN12 of the sense amplifier SA1 remains at $(1/2)$Vcc. Therefore, the voltage difference Vdiff between the voltages Vsn11 and Vsn12 becomes a input difference voltage of the differentiol type sense amplifier SA1, that is as follows:

$$Vdiff = (Cs/Cb)Vr,$$

wherein, Cb = Cd+Csa+Cs, Vr = $(1/2)$Vcc or $-(1/2)$Vcc.

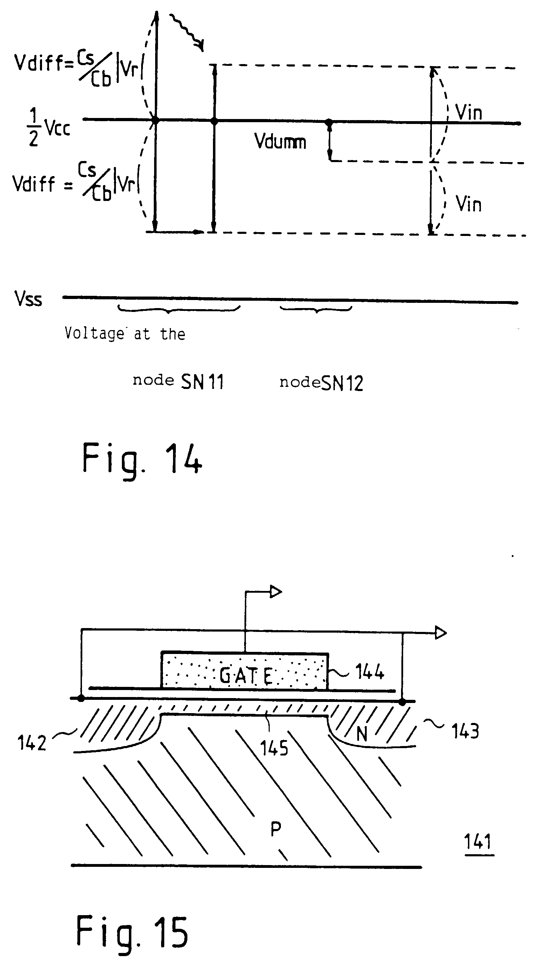

However, high voltages stored in memory capacitors, genarally in semiconductor devices, have tendencies to be decreased as a result of alpha-radiation, leakage currents or substrate currents and so on. Therefore the voltage difference Vdiff tends to be small in a case that the memory cell capacitor CC11 is written with a high voltage as shown in Figure 14. Thus, the dummy memory cells DC11, DC12 associated with a capacitance Cdumm are provided. When the word line WL1 is selected, the dummy word line driver DD selects the dummy word line DWL1 and decreases the voltage of it so as to pull down the voltage of the word line BL12 via the dummy cell capacitor DC12. The voltage of the node SN12 is also decreased to the voltage $(1/2)$Vcc-Vdumm. Therefore, the input voltage difference Vin of the sense amplifier SA1 becomes as follows:

$$Vin = Vdiff+Vdumm,$$

wherein, Vdumm = $(Cdumm/(Cd+Csa+Cdumm))$Vcc

Thus, the input voltage difference Vin of the sense amplifier SA1 is maintained at the same level as shown in Figure 14. That is, the input voltage difference Vin has the same value in both cases that the selected memory cell capacitor CC11 is written or non-written.

Therefore, when the control signals SAP, SAN become the voltages Vcc, Vss respectively and the sense amplifier SA1 is activated, the sense amplifier SA1 can detect and amplify the voltages on the bit lines BL11, BL12 correctly regardless of whether the cell capacitor CC11 is written or non-written. When the word line WL2 is selected, the dummy word driver DD select the dummy word line DWL2 and the operation of the device in this case is the same as the case described above. In this prior art device, the dummy cell capacitors are formed by using n-channel depletion transistors as shown in Figure 15, that is, a gate electrode 144 of each depletion transistor 141 is connected to one of dummy word lines whereas a source and a drain regions 142, 143 are commonly connected to one of bit lines, because the depletion transistors generally work as capacitors when the gate electrode voltages are positive owing to their channel region 145 connected to the source and drain region 142,143.

Accordingly, in the prior art device, since the memory cell capacitors are needed to have considerably large capacitances in order to decrease and adjust the voltages of bit lines BL12, BL12, the dummy cell capacitors are large. Moreover, since the dummy cell capacitors have diffusion regions 145, which need a mass of impurity injections, the capacitors tend to vary in their capacitances through the manufacturing processes from each other and cause errors in read operations of the device. Furthermore, the capacitance Cdumm is predetermined and can not be adjusted to compensate the variation of the capacitance Cs and Cd which occur through the manufacturing processes so that error occurs in read operations. Additionally, the depletion transistors need extra processes, for example, arsenic injection process, which take a considerably long time causing possibilities of damage to other element in the device such as memory cell capacitors CC11, CC21.

Therefore, the main object of the invention is to provide a semiconductor memory device having a small size and operating correctly.

The memory device has a differential type sense amplifier having each input/output node thereof connected to a dummy cell which includes an enhancement type transistor. The transistor is connected at its gate electrode to a dummy word line and at its source and drain electrodes to an input/output node of the sense amplifier. The dummy word driver decreases the voltage of the gate electrode of the transistor with a large capability. The capability can be selectively changed to adjust the voltage of the input/output node of the sense amplifier.

FIgure 1 shows a block diagram of a semiconductor memory device.

FIgure 2 shows a circuit configuration of a part of the device shown in Figure 1.

FIgure 3 shows a crosssectional view of a dummy cell transistor.

FIgure 4 is a timing chart of the operation of the device.

FIgure 5 is a graphic formula showing voltages of parts of the device.

FIgure 6 is a graphic formula showing a voltage of a part of the device.

FIgure 7 shows a circuit configuration of a part of the device.

FIgure 8 shows a circuit configuration according to the second embodiment of the invention.

FIgure 9 is a timing chart of the device.

FIgure 10 is a graphic formula showing voltages of parts of the device.

FIgure 11 is a graphic formula showing voltages of parts of the device.

Figure 12 is a circuit configuration according to the third embodiment of the invention.

FIgure 13 shows an example of semiconductor memory devices.

Figure 14 shows voltages of some parts of Figure 12.

FIgure 15 shows a crosssectional view of depletion transistors.

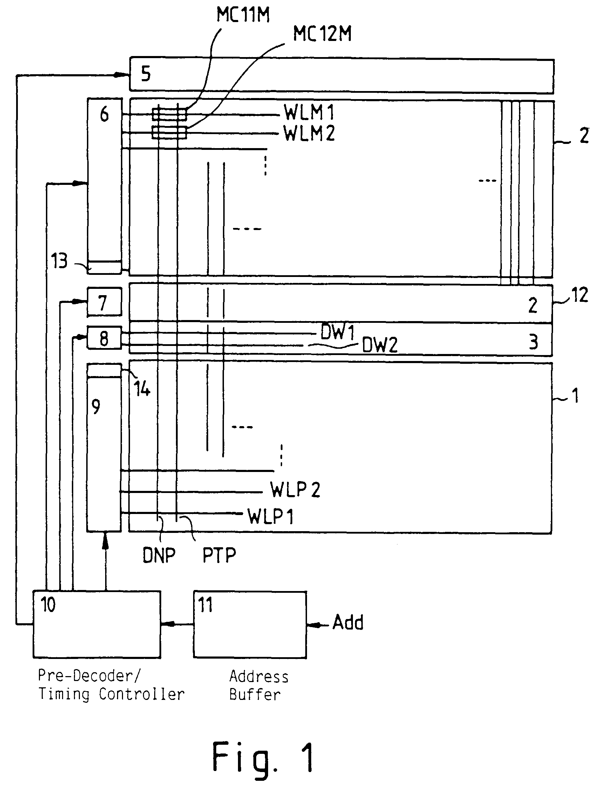

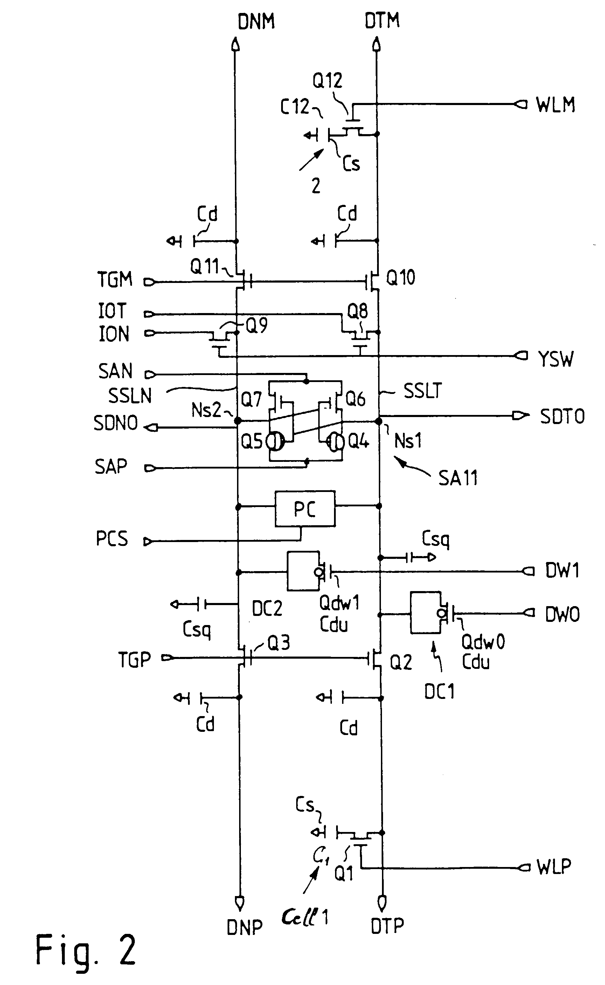

As shown in Figure 1, in a semiconductor memory device, according to the invention, a sense circuit 12 including a sense amplifier circuit 2 and a dummy cell circuit 3 is associated with each memory cell array 1 and 2. Word driver circuits 6 and 9 drive word lines WLM1, WLM2 and WLP1, WLP2 respectively whereas a dummy word driver 8 selectively drives dummy word lines DW1, DW0. A sense amplifier control circuit 7 activates sense amplifiers according to an output signal from a pre-decoder/timing control circuit 10 which is connected to an address buffer 11. That is, in this device, each sense amplifier SA11 in the sense amplifier circuit 2 is formed in a shared style in which the sense amplifier is associated with two pairs of bit lines DNM, DTM and DNP, DTP as shown in Figure 2.

In this device, each memory cell transistor Q1, Q12 is associated with a memory cell capacitor C1, C12 having a capacitance Cs and connected to one of bit lines DNP, DTP, DNM, DTM and one of word lines WLP, WLM. The bit lines DNP, DTP, DNM, DTM each having a parasitic capacitance Cd are selectively connected to the sense signal lines SSLN, SSLT in the sense circuit 12 via gate transistors Q2, Q3, Q10, Q11 as shown in Figure 2.

The gate transistors Q2, Q3, Q10, Q11 are formed in a small size with a comparatively large resistance when they are in conductive states. The gate transistors Q2, Q3, Q10, Q11 are controled by a cell array selection signal TGM, TGP output from cell array selection circuits 13,14. The sense signal lines SSLN, SSLT each having a parasitic capacitance Csa are connected to a sense amplifier SA11 and dummy cells DCN, DCT.

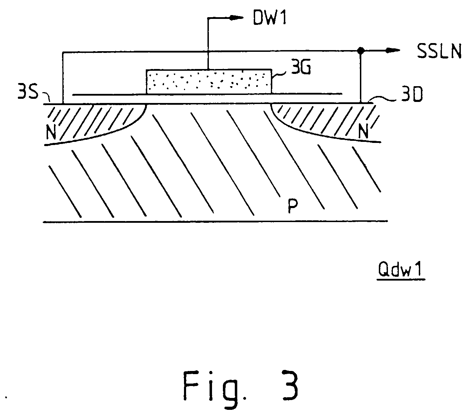

The dummy cell DCN, DOT is formed by using a enhancement type transistor Qdw1, Qdw0 as shown in Figure 3. Each dummy memory cell transistor Qdw1, Qdw0 has its gate electrode 3G connected to the dummy word line DW1, DW0 and its source and drain regions 3S, 3D connected to the sense signal line SSLN, SSLT. The enhancement transistor Qdw1, Qdw0 works as a capacitor when a channel region is formed, that is, when a voltage difference between a source and a gate electrodes is higher than the threshold voltage of it. Therefore, each dummy cell DCT, DCN is associated with a certain capacitance Cdu. The sense amplifier SA11 is activated according to the signals SAN, SAP. The column selector 5 selectively output the column selection signal YSW to transistors Q8, Q9 and read and write the data from or to the memory cells.

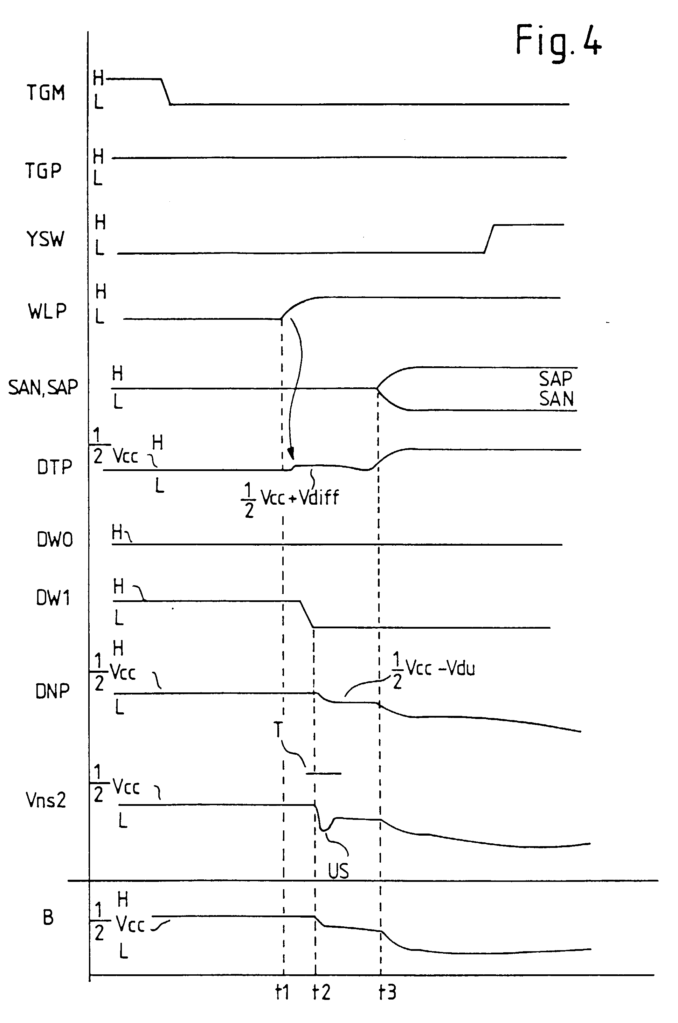

Now the read mode operation of this device will be described in a case where the memory cell Cell1 is selected as shown in Figure 4. The cell array selection circuit 14 outputs a selection signal TGP with its high level voltage whereas the selection circuit 13 outputs the signal TGM with its low level. Therefore the cell array is selected and bit lines DNP, DTP are connected to the signai lines SSLN, SSLT respectively. In this case, the bit lines and signal lines DNP, DTP, SSLN, SSLT are precharged to the voltage $(1/2)Vcc$ by a precharge circuit PC.

Subsequently, the word driver 9 selects the word lines WLP according to the address signal Add and drives the selected word line WLP to a high voltage, which is preferably higher than the voltage Vcc in order to bias the gate electrode of the memory cell transistors Q1, at the time tl as shown in Figure 3. The memory cell capacitor C1 is therefore connected to the bit line DTP and stored data is transffered to the bit line DTP and the signal line SSLT. In this case, during the preceeding write or refresh operation mode, the cell capacitor C1 is biased with the restore voltage VR which is as follows:

$$VR = (1/2)Vcc+Vr,$$

wherein, $Vr = (1/2)Vcc$ or $-(1/2)Vcc$. That is, the cell capacitor C1 is charged to the voltage Vcc for representing "written" state, or discharged for representing "non-witten" state. In this case, as shown in Figure 3, the cell C1 is in "written" state. Therefore, when the voltages of the bit line DTP, signal line SSLT and the memory cell capacitor C1 are balanced, the voltage Vnsl of the node Ns1 is as follows:

$$Vns1 = (1/2)Vcc + Vdiff,$$

wherein, $Vdiff = (Cs/Cb)Vr,$

$$Cb = Cd+Csa+Cs.$$

However, the voltage Vnsl has a tendency to become small because of the alpha-radiation, leakage currents and so on, which are tend to occur in semiconductor devices.

Therefore, at the time t2, as shown in Figure 3, dummy word driver 8 selects the dummy word lines DW1, DW2 according to the address signal Add and decreases the voltage of the dummy word line DW1 which is associated with the bit line DNP. That is, the dummy word driver 8 selects one of the dummy word lines WD0, WD1 which is not connected to the selected memory cell Cell1. The dummy memory cell DCN is preliminary charged to the voltage $(1/2)Vcc$ which is the difference of voltages of the signal line SSLT and the dummy word line DW1 during a precharge operation mode of this device. Therefore, after the voltage of the dummy word line DWl is decreased to the voltage Vss, that is a ground voltage, as a result of the capacitance Cdu of the dummy cell transistor Qdwl, the voltage Vns2 of the node Ns2 becomes lower than the voltage $(1/2)Vcc$, which is as

follows:

$$Vns2 = (1/2)Vcc - Vdu.$$

Therefore the voltage difference between the voltages of the nodes Ns1, Ns2, which is an input voltage Vin of the sense amplifier SA11, is as follows:

$$Vin = Vns1 - Vns2 = Vdiff + Vdu.$$

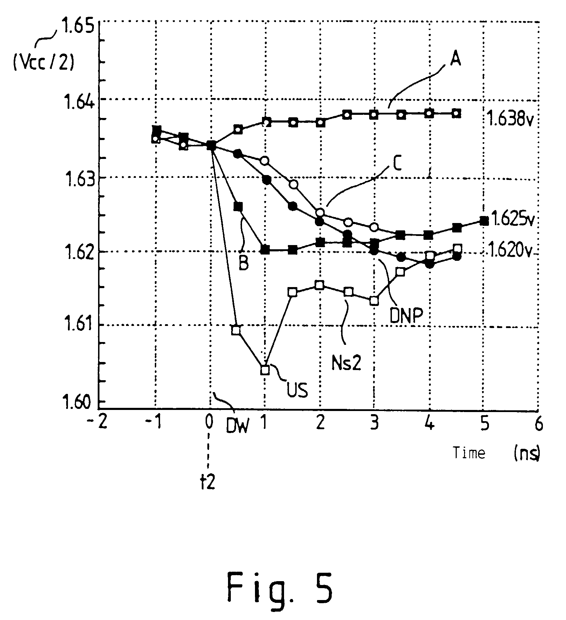

Although the value of the decrease voltage Vdu is basically determined by the capacitances Csa, Cd and Cdu, the capacitance Cdu depends on the voltages of a source and a gate electrodes of the memory cell transistor Qdw1 and the actual performance is dynamic so that the accurate arithmetic for the value of Vdu would be complicated. Therefore, a result of the simulation for the voltages of the node Ns2 and the bit line DNP is shown in Figure 5.

The simulation corresponds to the time period T shown in Figure 5, setting the time 2, that is when the dummy word line DW1 goes to low level, at the starting point of the time axis. In this simulation, the voltage Vcc is set at 3.3 volts. The graph labeled "A" shows a voltage of the node Ns2 in the case where no memory cell or dummy cell associated with the node Ns2 is selected. The voltage of the node Ns2 in the graph A is decreased from 1.65V, that is the voltage $(1/2)Vcc$, to 1.638V as a result of the capacitance coupling between the signal line SSLN and the gate transistor Q11 which occured when the signal TGM was decreased preceedingly in order to disconnect the bit line DNM from the signal line SSLN. However, the capacitance couplings with the gate transistors Q10, Q11 are effective in both of the signal lines SSLN, SSLT so that the coupling effects on the signal lines SSLN, SSLT do not cause any variations of the input voltage Vin of the sense amplifier SA11.

The voltage Vns2 of the node Ns2 is strongly pulled down with a decrease of the voltage of the dummy word line DW1, as labeled "US" in Figure 4. The decrease US of the voltage Vns2 is caused by the gate transistor Q3 which is formed to have a comparatively large resistance and causes only a small current therethrough. Moreover, the decrease US is also regarded as a result of the dynamic performance of the dummy cell transistor Qdw1. That is, when the voltage Vdw1 of the dummy word line DW1 is decreased and the dummy cell transistor Qdw1 works as a capacitor pulling down the voltage Vns2, owing to the quick decreasings of the voltages Vdw1, Vns2 which are performed in such short time as subnanoseconds, as shown in Figure 5, the voltage of the source region 3S of the dummy cell transistor Qdw1 are also decreased and the dummy cell transistor Qdw1 continues to work as a capacitor. Therefore the effective capacitance Cdu of the transistor Qdw1 is increased and the voltage Vns2 is highly decreased in spite that the transistor Qdw1 is a enhancememt type transistor.

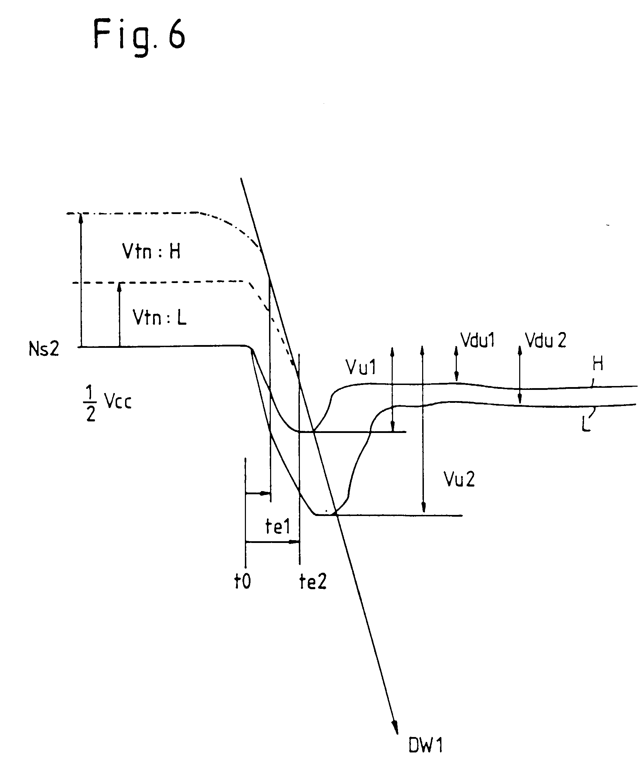

Furthermore, in this case, owing to the resistance of the gate transistor Q3, the voltage Vns2 is maintained in a low voltage and, therefore, further decreased. That is, the more the voltage Vns2 is decreased, the more the volltage of the source region 3S is decreased and the more the effective capacitance Cdu of the transistor Qdw1 is increased. Additionally the voltage Vns2 causes the undershoot effect caused by the dynamic action of itself, as shown in Figure 6, so as to strengthen the decrease further. Therefore, actually, even when this dynamic performance of the transistor Qdw1 is finished, the voltage Vns2 maintains its low voltage level as shown in Figure 5. The graphs labeled "B" and "C" show respectively the voltages of the node Ns2 and the bit line DNP in the case where the gate transistor Q3 has a smaller resistance than that in the case described above.

Therefore, the voltage Vns2 becomes sufficiently small so as to compensate the tendency of the voltage Vns1 to become small and provides the input voltage Vin for the sense amplifier SA11 appropriate in both cases where the memory cell C1 is "written" or "non-written". So that when the sense amplifier SA11 is activated by the signals SAN, SAP at the time t3, as shown in Figure 4, the sense amplifier SA11 detects and amplifies the voltage difference between the nodes Ns1, Ns2 correctly. Subsequently, the column selection signal YSW becomes high level and the data in the sense amplifier circuit 2 is output to the column selector 5.

Consequently, in this device, according to the invention, the dummy cell transistors Qdw1, Qdw0 can be formed in a small size decreasing the total area of the device without causing operation errors in the read mode. Moreover, since the dummy cell transistors Qdw1, Qdw0 are enhancement transistors, which have uniform properties such as the threshold voltage and the effective capacitances, the possibility of operation errors is decreased. Furthermore, in this embodiment, since the gate transistors for selecting the memory cell array are used as resistance means which provide the decrease of the voltage Vns2, any increase in the device area is not caused.

Figure 6 shows the voltage Vns2 of the node Ns2 in the two cases where the dummy cell transistor Qdwl has a high and a low threshold voltages. As mentioned above, the effective capacitance Cdu of the dummy cell transistors Qdw1, Qdw0 depends on the threshold voltage of them. Therefore, when the transistor Qdw1 initially has a low threshold voltage, as labeled "Vtn: L" in Figure 6, the transistor Qdw1 can maintain its threshold voltage smaller than the voltage of the dummy word line DW1 from the time t0 to the time te2, which is longer than that in the case labeled "Vtn: H". Therefore, while in both cases the voltage Vns2 causes the undershoot effect, the voltage Vns2 has a larger decrease of Vu2 during the under shoot effect and a larger decrease of Vdu2 in the final state in the case of the low threshold voltage. So that it is preferable for the dummy cell transistors Qdw1, Qdw0 to have a low threshold voltage in order to provide a large amount of the decrease voltage Vdu. It is also possible to adjust the threshold voltage of the dummy cell transistors Qdw1, Qdw0 so as to provide the appropriate voltage Vin. In this case, the adjustment of the threshold voltages does not need so much amount of the impulity injections that the properties of transistors vary. Therefore the reliability of the device is not decreased.

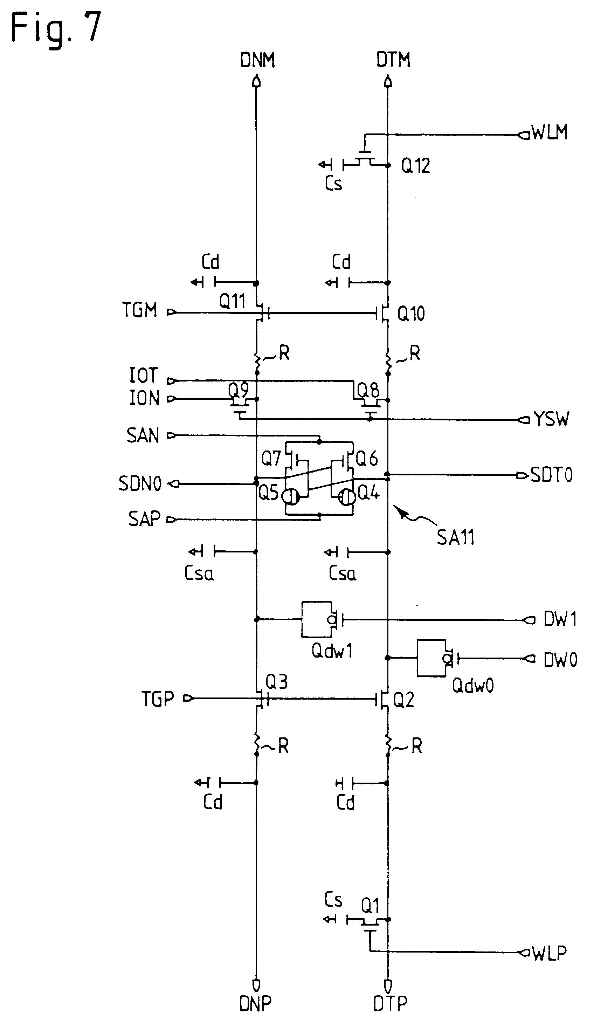

In this device, the resistance of the gate transistors Q2, Q3, Q10, Q11 can be provided by many ways, for example, by forming the channel region narrow or long, or by impurity injections to the channel region. The resistance of the transistors Q2, Q3, Q10, Q11 is also increased if the voltage level of the dummy word line DW1, DW0 is set at a lower voltage level. However, it is also possible to equip the device with other resistance means R which are placed between the bit lines DNP, DTP, DNM, DTM and the dummy cell transistors Qdw1, Qdw0, as shown in Figure 7.

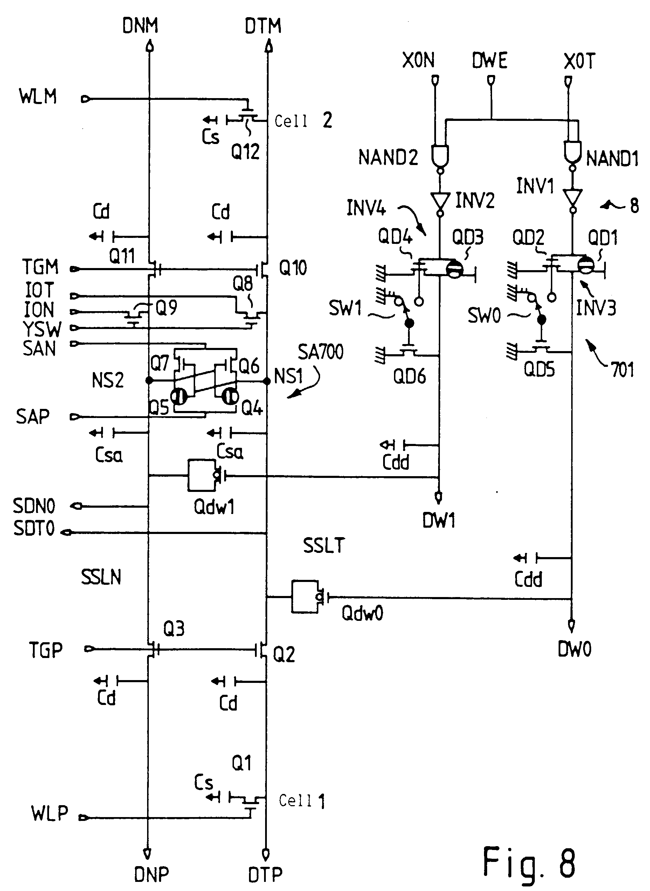

The second embodiment of the invention will be described. As shown in Figure 8, a semiconductor memory device of this embodiment has a dummy word line control circuit 701 in the dummy word driver 8. The dummy word line control circuit 701 includes inverters INV3, INV4 each supplied with an output signal of a inverter INV1, INV2 respectively. The inverter INV3 has a p-channel transistor QD1 and n-channell transistors QD2, QD5 whereas the inverter INV4 has a p-channel transistor QD3 and n-channell transistors QD4, QD6. The gate electrodes of the transistors QD5, QD6 are selectively connected to the gate electrodes of the transistors QD2, QD4 respectively by the switching means SW0, SW1.

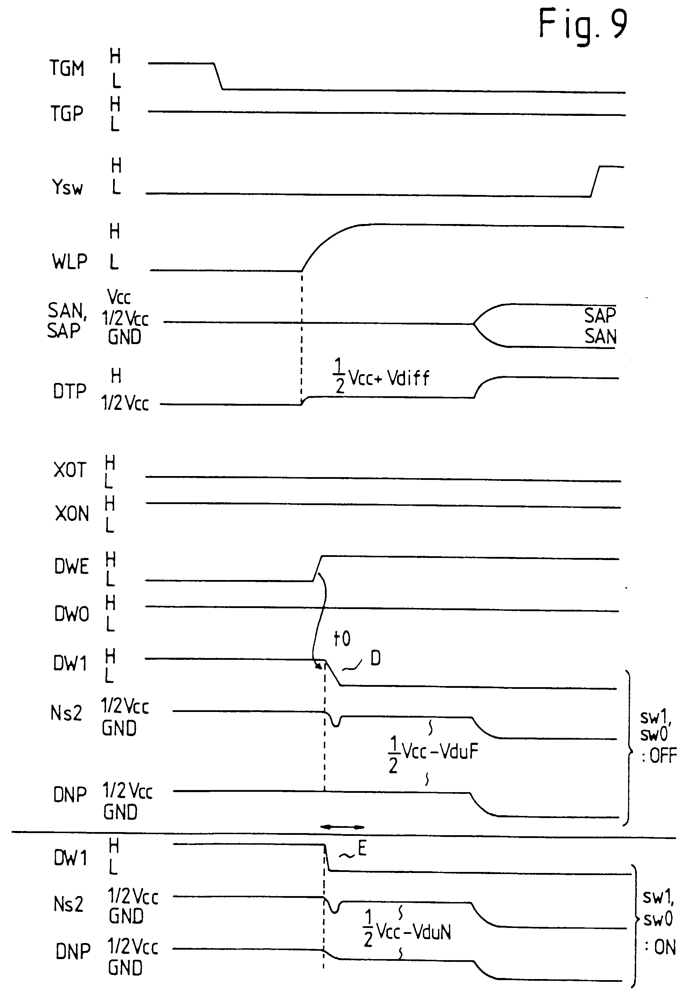

As shown in Figure 9, after the cell array selection signal TGM becomes low and the bit lines DTM, DNM are disconnected from the sense signal lines SSLN, SSLT, the selected word line WLP becomes high and, according to the stored data of the selected memory cell Celll, the voltage of the bit line DTP becomes the voltage (1/2)Vcc+Vdiff. Meanwhile, according to the address signal Add, the dummy word line selection signals X0N, X0T are supplied to the dummy word driver 8 in order to designate the dummy word line DW1 corresponding to the bit line DNP which is not associated with the selected memory cell, as mentioned above. The switching means SW1, SW0 are, in this case, in a "OFF" state. Therefore, when the dummy word driver control signal DWE goes to high, the inverter INV4 drives the dummy word line DW1, which is associated with the capacitance Cdd, to the ground voltage Vss by a driving capability of the transistor QD4. The voltage of the dummy word line DW1 decreases in a certain speed which is determined by the capacitance Cdd and the driving capability of the transistor QD4 as indicated as "D" in Figure 9. So that the voltage Vns2 of the node Ns2 is pulled down via dummy cell transistor Qdwl to the voltage (1/2)Vcc- VduF.

On the other hand, if the switching means SW1, SW0 are in a "ON" state, the inverter INV4 drives the dummy word line DW1 to the ground voltage Vss by using both of the transistors QD4, QD6. Therefore, the capacitance Cdd of the dummy word line WL1 is discharged in a higher speed which is determined by the capacitance Cdd and the driving capability of the transistors QD4, QD6. So that the voltage of the dummy word line DW1 decreases more quickly, indicated as "E" in Figure 9, than in the case indicated as "D" and the voltage Vns2 of the node Ns2 becomes (1/2)Vcc-VduN.

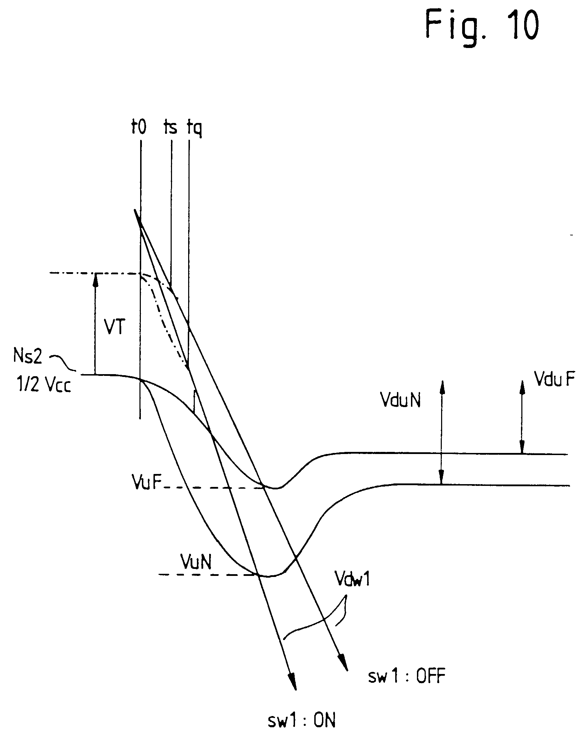

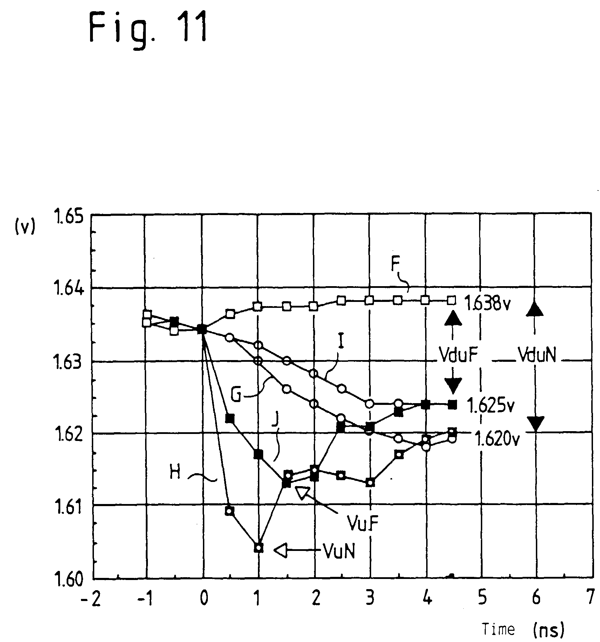

That is, as mentioned above, since the decrease of the voltage Vdwl has an effect of decreasing the voltage of the source region 3s, and the voltage of the source region is maintained by resistor means, the more the voltage Vdwl is decreased quickly, the more the effective capacitance Cdu is increased. Therefore, As shown in Figure 10, 11, when the switching means SW1 is "ON", indicated as "G", "H", the voltage Vdwl of the dummy word line DW1 is decreased quickly and the transistor Qdwl works as a capacitor from to to tq causing an undershoot to VuN so that finally the voltage of the node Ns2 become (1/2)Vcc-VduN, which is lower than the case where the switching means SW1 is "OFF", indicated as "I", "J".

In this case, when the capacitances Cs, Csa, Cd are changed through the manufacturing processes and therefore the input voltages Vin corresponding to the cases where the selected memory cell is written and non-written respectively, the switching means SW1, SW0 are controlled to be on or off in order to adjust the voltage Vdu and compensate the variations of the capacitances Cs, Csa, Cd. Other operations of this device are almost the same as in the device of the first embodiment.

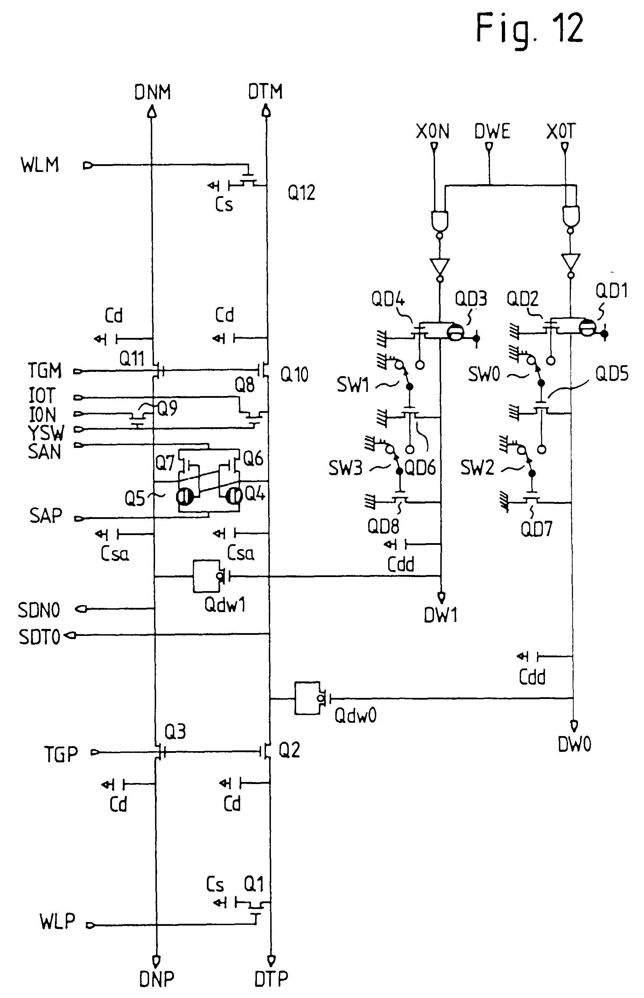

Although this device is equipped with a control circuit for selecting two driving capabilities of the dummy word driver 8, as shown in Figure 12, it is also possible to provide a control circuit for selecting four capabilities of the dummy word driver 8. Other variations for controlling the decrease speed of the voltage of dummy word lines so as to adjust the effective capacitance of dummy cells are easily provided according to the present invention.

## Claims

1. A semiconductor memory device comprising:

   a) a plurality of sense amplifiers (SA11) each having a first and a second node (Ns1, Ns2);
   b) a plurality of first bit lines (DTP) each associated with one of said sense amplifiers;
   c) a plurality of second bit lines (DNP) each associated with one of said sense amplifiers;

   d) a plurality of first word lines (WLP);
   e) a plurality of first memory cells (Cell 1) each associated with one of said first word lines and one of said bit lines;
   f) a plurality of dummy cells (DC2) each having first and second electrodes;
   g) a word driver (6, 9) for selectively connecting said first memory cells to said first bit lines; and
   h) a dummy word driver (8) for supplying a selection signal to said first electrode of a selected one of said first dummy cells,

   characterized in that said semiconductor memory device further comprises:

   i) a plurality of first transfer gates (Q2) each interposed between an associated one of said first bit lines and said first node of an associated one of said sense amplifiers: and
   j) a plurality of second transfer gates (Q3) each interposed between an associated one of said second bit lines and said second node of an associated one of said sense amplifiers, wherein

   each of said first dummy cells comprises a transistor of an enhancement type, and wherein said second electrode of each of said dummy cells is connected to said second node of an associated one of said sense amplifiers without an intervention of said second transfer gate.

2. The semiconductor memory device as claimed in claim 1, characterized in that said dummy word driver is equipped with a control means which controls a driving capability of said dummy word driver to adjust a voltage of said second node.


## Patentansprüche

1. Halbleiterspeicheranordnung mit:

   a) mehreren Leseverstärkern (SA11) mit jeweils einem ersten und einem zweiten Knoten (Ns1, Ns2);
   b) mehreren ersten Bitleitungen (DTP), die jeweils einem der Leseverstärker zugeordnet sind;
   c) mehreren zweiten Bitleitungen (DNP), die jeweils einem der Leseverstärker zugeordnet sind;
   d) mehreren ersten Wortleitungen (WLP);
   e) mehreren ersten Speicherzellen (Cell1), die jeweils einer der ersten Wortleitungen und einer der Bitleitungen zugeordnet sind;
   f) mehreren Leerzellen (DC2) mit jeweils ersten und zweiten Elektroden;
   g) einem Worttreiber (6, 9) zum selektiven Verbinden der ersten Speicherzellen mit den ersten Bitleitungen; und

h) einem Leerworttreiber (8) zum Übergeben eines Wählsignals an die erste Elektrode einer gewählten der ersten Leerzellen,

dadurch gekennzeichnet, daß die Halbleiterspeicheranordnung ferner aufweist:

i) mehrere erste Transfergatter (Q2), die jeweils zwischen einer zugeordneten der ersten Bitleitungen und dem ersten Knoten eines zugeordneten der Leseverstärker angeordnet sind; und
j) mehrere zweite Transfergatter (Q3), die jeweils zwischen einer zugeordneten der zweiten Bitleitungen und dem zweiten Knoten eines zugeordneten der Leseverstärker angeordnet sind, wobei

jede der ersten Leerzellen einen Transistor eines Anreicherungstyps aufweist und wobei
die zweite Elektrode jede der Leerzellen mit dem zweiten Knoten eines zugeordneten der Leseverstärker ohne eine Beteiligung des zweiten Transfergatters verbunden ist.

2. Halbleiterspeicheranordnung nach Anspruch 1, dadurch gekennzeichnet, daß der Leerworttreiber mit einer Steuereinrichtung ausgerüstet ist, die eine Treiberfähigkeit des Leerworttreibers steuert, um eine Spannung des zweiten Knotens zu ändern.

**Revendications**

1. Dispositif de mémoire à semi-conducteurs comprenant :

a) une pluralité d'amplificateurs de lecture (SA11) chacun ayant un premier et un deuxième noeuds (Ns1, Ns2);
b) une pluralité de premières lignes de bit (DTP), chacune associée à l'un desdits amplificateurs de lecture;
c) une pluralité de deuxièmes lignes de bit (DNP), chacune associée à l'un desdits amplificateurs de lecture;
d) une pluralité de premières lignes de mots (WLP);
e) une pluralité de premières cellules de mémoire (*Cell*1), chacune associée à l'une desdites premières lignes de mot et à l'une desdites lignes de bit;
f) une pluralité de cellules fictives (DC2), chacune ayant des première et deuxième électrodes;
g) un coupleur de mot (6, 9) pour connecter sélectivement lesdites premières cellules de mémoire auxdites premières lignes de bit; et
h) un coupleur de mot fictif (8) pour fournir un signal de sélection à ladite première électrode d'une cellule sélectionnée desdites premières cellules fictives,

caractérisé en ce que ledit dispositif de mémoire à semi-conducteurs comprend en outre :

i) une pluralité de premières portes de transfert (Q2), chacune interposée entre une ligne associée desdites premières lignes de bit et ledit premier noeud d'un amplificateur associé desdits amplificateurs de lecture; et
j) une pluralité de deuxièmes portes de transfert (Q3), chacune interposée entre une ligne associée desdites deuxièmes lignes de bit et ledit deuxième noeud d'un amplificateur associé desdits amplificateurs de lecture,

dans lequel chacune desdites premières cellules fictives comprend un transistor d'un type à enrichissement,
et dans lequel ladite deuxième électrode de chacune desdites cellules fictives est connectée audit deuxième noeud d'un amplificateur associé desdites amplificateurs de lecture sans une intervention de ladite deuxième porte de transfert.

2. Dispositif de mémoire à semi-conducteurs selon la revendication 1, caractérisé en ce que ledit coupleur de mot fictif est équipé de moyens de commande qui commandent une capacité de commande dudit coupleur de mot fictif pour ajuster une tension dudit deuxième noeud.

Fig. 1

Fig. 2

Fig. 3

Fig. 4

Fig. 5

# Fig. 6

# Fig. 7

Fig. 8

# Fig. 9

# Fig. 10

# Fig. 11

# Fig. 12

# Fig. 13

EP 0 595 329 B1

$$Vdiff = \frac{Cs}{Cb}|Vr|$$

$$\frac{1}{2}Vcc$$

$$Vdiff = \frac{Cs}{Cb}|Vr|$$

Vdumm

Vin

Vin

Vss

Voltage at the

node SN 11          node SN 12

# Fig. 14

GATE   ~ 144

142 ~   145   N   ~ 143

P   141

# Fig. 15